# EUROPÄISCHE PATENTSCHRIFT

(11) **EP 1 937 049 B1**
(45) Veröffentlichungstag und Bekanntmachung des Hinweises auf die Patenterteilung: **14.04.2010**
(21) Anmeldenummer: 06026797.8
(22) Anmeldetag: 22.12.2006
(51) Int. Cl.: H05K 9/00, E04B 1/80

(54) **Dämmplatte mit Sandwichstruktur zum Schutz vor elektromagnetischer Strahlung**
Insulating board with a sandwich structure as protection against electromagnetic waves
Panneau isolant doté d'une structure en sandwich destiné à la protection contre le rayonnement électromagnétique

(43) Veröffentlichungstag der Anmeldung: 25.06.2008
(73) Patentinhaber: Pavatex SA, 1701 Fribourg (CH)
(72) Erfinder: Hänel, Annemarie, 6003 Luzern (CH); Brombacher, Volker, 5644 Auw (CH)
(74) Vertreter: Sutter, Kurt

(56) Entgegenhaltungen:
- WO-A-02/052086
- WO-A-2004/020930
- JP-A- 10 196 002
- US-A- 5 974 757
- US-A1- 2002 194 805

## Beschreibung

Die Erfindung betrifft eine mehrschichtige Dämmplatte mit einer innen liegenden Schutzschicht, deren Herstellung und Verwendung sowie ein Verfahren zum Schützen und Dämmen von Gebäuden oder Gebäudeteilen mittels der erfindungsgemässen Dämmplatte.

Dämmplatten für die thermische Dämmung oder akustische Dämmung (z.B. Trittschall) sind bekannt. Solche Platten können als z.B. Wand-, Zwischenwand-, Decken-, Unterdach- oder Trittschallplatten ausgebildet sein. Auch sind Folien und Netze zur Isolierung von Gebäuden oder Gebäudeteilen vor elektromagnetischer Strahlung bekannt. Um Gebäude oder Gebäudeteile vor elektromagnetischer Strahlung zu Schützen und gleichzeitig zu Dämmen sind somit mehrere Arbeitsschritte nötig, was zeit- und kostenintensiv ist.

Des Weiteren offenbart US5008486 ein Paneel mit aussen liegender elektrisch leitender Folie und darüber liegendem elektrisch leitendem Netz sowie dessen Verwendung zur Abschirmung von Räumen. Dieses Paneel benötigt aufgrund seiner speziellen, mehrlagigen Struktur eine aufwendige Fertigung. Des Weiteren ist die Schutzschicht an der Aussenseite des Paneels angebracht, was sie anfällig gegen Beschädigung und kompliziert in der Montage macht.

Des Weiteren offenbart W02004/020930 eine Abschirmvorrichtung aus gegeneinander versetzten planaren Elementen, welche elektromagnetische Abschirmung bewirken. Die beschriebene Abschirmvorrichtung weist jedoch keine dämmenden Eigenschaften auf.

Des Weiteren beschreibt US5974757 akustische Dämmplatten bestehend aus mehreren miteinander verbundenen Plattenelementen, die auf ihrer Innenseite mit mindestens 2 Metallfolien beschichtet sind.

Des Weiteren beschreibt W02004/020930 Dämmplatten aus einzelnen Plattenelementen bei welchen allseitig eine Stufe zwischen den einzelnen Elementen vorgesehen ist; die Möglichkeit einer zwischenliegenden Schutzschicht wird nicht angedeutet.

Zusammenfassend weisen die bekannten Dämmelemente eine Reihe von Nachteilen auf; so sind sie aufwändig zu produzieren und / oder zu verarbeiten und / oder mit den üblichen Verarbeitungstechniken im Baugewerbe nicht oder schlecht kompatibel. Des Weiteren weisen die bekannten Elemente nur eine Dämmwirkung oder Schutzwirkung auf.

Aufgabe der vorliegenden Erfindung ist es daher, eine Dämmplatte zur Verfügung zu stellen, welche die genannten Nachteile nicht aufweist.

Diese Aufgabe wird durch eine Dämmplatte gemäss Anspruch 1 gelöst. Vorteilhafte Ausführungsformen sind in der Beschreibung und den abhängigen Ansprüchen angegeben. Weitere Aspekte der Erfindung sind in den unabhängigen Ansprüchen sowie in der Beschreibung angegeben.

Die in nachfolgend aufgeführten allgemeinen, bevorzugten und besonders bevorzugten Ausführungsformen, Definitionen und Alternativen können beliebig miteinander kombiniert werden und sind Gegenstand der vorliegenden Erfindung. Des Weiteren können einzelne Definitionen / Alternativen entfallen.

Die Erfindung wird weiterhin illustriert durch die Figuren, wobei Fig. 1 eine erfindungsgemässe Dämmplatte in der Aufsicht zeigt; Fig. 2 zwei bündig miteinander verlegte Dämmplatten in der Seitenansicht zeigt; Fig. 3 die Detailansichten von bündig miteinander verlegten Dämmplatten in der Seitenansicht zeigt, wobei verschiedene mögliche Kantenprofile dargestellt werden und Fig. 4 ein Beispiel für die Verlegung der erfindungsgemässen Dämmplatten zeigt.

In einem **ersten Aspekt** betrifft die Erfindung daher eine mehrschichtige Dämmplatte bestehend aus zwei Plattenelementen und mindestens einer ganzflächig dazwischen liegenden Schutzschicht, dadurch gekennzeichnet, dass a)die Plattenelemente relativ zueinander versetzt befestigt sind, derart dass allseitig eine Stufe zwischen diesen Platten gebildet wird und b)die Schutzschicht die gebildete Stufe mindestens zur Hälfte bedeckt.

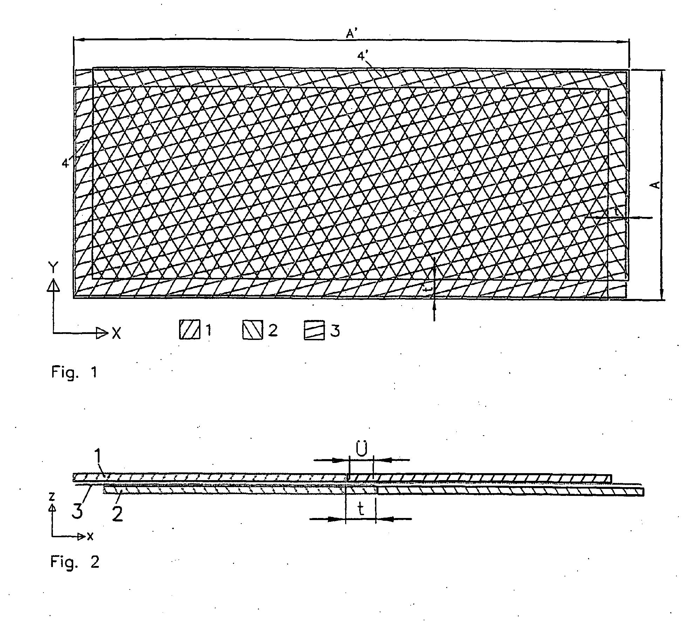

Die erfindungsgemässe Dämmplatte weist mehrere Schichten auf, die übereinander - sandwichartig - angeordnet und miteinander verbunden sind. Die einzelnen Schichten sind, wie nachfolgend beschrieben, in der Ebene ihrer flächigen Erstreckung (vgl Fig. 1: in X- und Y-Richtung) gegeneinander versetzt. Die Schichten der Dämmplatte lassen sich als "obere Schicht" (1), "Schutzschicht" (3) und "untere Schicht" (2) beschreiben.

Die obere und untere Schicht bestehen jeweils aus Plattenelementen, wobei das obere und untere Plattenelement aus dem gleichen oder verschiedenen Material bestehen können. Das Material solcher Plattenelemente entspricht dem bekannter Dämmplatten. Geeignet sind z.B. Kunststoffe, Holzfaserplatten, Holz und Verbundmaterialien. Die Plattenelemente ihrerseits können wiederum eine Sandwichstruktur aufweisen, wie z.B. Holzfaserplatten unterschiedlicher Dichte oder beschichtete / lackierte Kunststoffplatten.Die Form der Plattenelemente kann in weiten Bereichen variiert werden, muss jedoch so gewählt werden, dass mehrere Dämmplatten bündig aneinander gesetzt werden können. Unter "bündig" wird im Zusammenhang mit der vorliegenden Erfindung ,,im wesentlichen ohne Zwischenraum" bzw. ,,ohne Zwischenraum" verstanden. Aufgrund der einfachen Herstellung und Montage sind Plattenelemente mit mindestens einem parallelen Kantenpaar (z.B. rechteckig) bevorzugt. Eine andere Form (z.B. sechseckig) kann auch verwendet werden, insbesondere, falls der Dämmplatte nach der Montage auch eine gestalterische Funktion zukommt.

Gemäss vorliegender Erfindung sind die Plattenelemente derart zueinander relativ versetzt, dass allseitig eine Stufe (4), (4') zwischen diesen Platten gebildet wird. Die Situation wird in Fig. 1 am Beispiel einer rechteckigen Dämmplatte illustriert. Sofern die verwendeten Plattenelemente zumindest ein paralleles Kantenpaar aufweisen, ist es bevorzugt, wenn dieses Kantenpaar der beiden Plattenelemente parallel zueinander verschoben wird, wodurch sich eine Stufe mit konstanter Tiefe ergibt. Sofern die verwendeten Plattenelemente zwei parallele Kantenpaare (rechteckige oder quadratische Grundfläche) aufweisen, ist es bevorzugt, wenn die beiden Plattenelemente so verschoben werden, dass sich eine umlaufende Stufe mit konstanter Tiefe ergibt.

In einer vorteilhaften Ausführungsform bedeckt die Schutzschicht die gebildete Stufe mindestens zur Hälfte und reicht im Wesentlichen nicht über die äussere Begrenzung (A), (A') der Dämmplatte hinaus.

In einer besonders vorteilhaften Ausführungsform entspricht die Fläche der Schutzschicht im Wesentlichen der äusseren Begrenzung (A), (A') der Dämmplatte und ist so positioniert, dass sie nicht über diese äussere Begrenzung hinausragt.

Weiterhin sind die Plattenelemente miteinander befestigt. Das Verbinden von oberen Plattenelement, Schutzschicht und unteren Plattenelement (das Befestigen) kann mit allen gängigen Verbindungstechniken des Formschlusses (z.B. mittels Clip, Klammer), Kraftschlusses (z.B. mittels Schrauben) oder Stoffschlusses (z.B. mittels Kleben oder Schweissen) erfolgen. Verschiedene Verbindungstechniken können auch miteinander kombiniert werden. Als bevorzugte Ausführungsform hat sich das Verkleben, z.B. mit PVAc-Leim oder Silikaten, erwiesen. Die Befestigung von Plattenelementen und Schutzschicht ist in den Figuren nicht dargestellt.

Die Schutzschicht besteht aus einem an die gewünschte Funktion angepassten Material. Zum Schutz z.B. vor elektromagnetischer Strahlung sind Folien oder Gewebe / Gelege aus elektrisch sehr gut leitendem Material (z.B. Kupfer, Aluminium, Edelstahl) geeignet. Ebenfalls umfasst von der vorliegenden Erfindung sind solche Dämmplatten, die mehrere Schutzschichten aus dem gleichen Material oder aus verschiedenen Materialien aufweisen.

Die Schutzschicht muss so angebracht sein, dass sie mit beiden Plattenelementen vollflächig im Kontakt ist und zusätzlich noch einen Überlappungsbereich mit der Schutzschicht einer angrenzenden Dämmplatte bildet. Ein Überlappungsbereich von ca. 5 mm ist in vielen Fällen ausreichend. Für eine optimale Schutzwirkung ist ein Überlappungsbereich von mindesten 10 mm, bevorzugt 30 - 50 mm vorteilhaft.

In einer vorteilhaften Ausführungsform weist die Dämmplatte wie vorstehend beschrieben zwei Plattenelemente mit identischer Grundfläche auf. In dieser Ausführungsform ist Herstellung und Verarbeitung / Verlegung der Dämmplatten besonders einfach, da z.B. beim Verlegen nicht zwischen Vorder- und Rückseite der Dämmplatte unterschieden werden muss.

In einer weiteren vorteilhaften Ausführungsform weist die Dämmplatte wie vorstehend beschrieben, eine Schutzschicht aus einer sehr gut elektrisch leitenden Folie und / oder Gewebe und/oder Gelege auf. Diese Ausführungsform ist besonders geeignet zur Abschirmung von elektrischen, elektromagnetischen oder magnetischen Feldern. Geeignete Folien / Gewebe / Gelege sind bekannt und kommerziell erhältlich oder nach bekannten Verfahren herstellbar.

In einer weiteren vorteilhaften Ausführungsform weist die Dämmplatte wie vorstehend beschrieben, eine Schutzschicht aus einem Drahtgewebe mit einer Maschenweite von < 5 mm auf. Bevorzugt wird das Drahtgewebe aus Kupfer, z.B. Reinkupfer hergestellt. Die Verwendung eines Drahtgewebes mit der angegebenen Maschenweite bewirkt einerseits eine gute Schutzwirkung gegen elektrische, magnetische oder elektromagnetische Felder und ermöglicht andererseits eine einfache Herstellung der Dämmplatte, z.B. durch Verkleben der Plattenelemente mit PVAc-Leim. So ist eine einseitige Auftragung mit Klebstoff ausreichend, um beide Plattenelemente mit der dazwischen liegenden Schutzschicht dauerhaft zu verbinden. Die Dämmplatte wie hier beschrieben zeigt neben der dämmenden Wirkung insbesondere auch eine sehr gute abschirmende Wirkung gegen hochfrequente elektromagnetische Strahlung und niederfrequente elektrische Wechselfelder.

Die beiden Plattenelemente der erfindungsgemässen Dämmplatte können aus beliebigem, der späteren Funktion der Dämmplatte angepassten Material hergestellt sein. Des Weiteren können die beiden Plattenelemente aus dem gleichen oder verschiedenen Material gefertigt werden. Jedes Plattenelement kann selbst eine Sandwichstruktur aufweisen, um z.B. verschiedene Funktionen optimal zu erfüllen. Als solche Funktionen wären Schalldämmung, Wärmedämmung, Tragfähigkeit, Wetterbeständigkeit zu nennen. In einer vorteilhaften Ausführungsform weist die Dämmplatte wie vorstehend beschrieben daher Plattenelemente aus einem Kunststoffmaterial und/oder Holzfasermaterial und/oder Holz auf. In einer besonders bevorzugten Ausführungsform weist die Dämmplatte wie vorstehend beschrieben Plattenelemente aus Holzweichfaserplatten, typischerweise mit einer Rohdichte von 100 - 300 kg/m3, auf.

Die Geometrie der erfindungsgemässen Dämmplatte wird durch die Geometrie der beiden Plattenelemente (Grundfläche und Dicke) und Ihren Versatz bestimmt. Wie vorstehend ausgeführt, werden die Plattenelemente so versetzt, dass eine allseitige Stufe gebildet wird. Durch den Versatz verläuft diese Stufe teilweise oberhalb, teilweise unterhalb der Sichtfläche. Der Versatz kann so ausgeführt werden, dass die umlaufende Stufe an allen Seiten die gleiche Tiefe aufweist, oder dass unterschiedliche Tiefen gebildet werden. Als Untergrenze wird allgemein 5 mm für die Stufentiefe angesehen. Als günstig haben sich Stufen mit einer Tiefe von 10 - 100 mm, bevorzugt 20 - 80 mm, z.B. 50 mm erwiesen. Weiterhin bevorzugt ist ein Versatz, der eine allseitige Stufe mit der gleichen Tiefe aufweist.

Die Dicke der erfindungsgemässen Dämmplatte kann in einem weiten Bereich variieren und hängt von Ihrer Funktion ab. Im Allgemeinen liegt die Dicke der Dämmplatte im Bereich von 5 - 200 mm, bevorzugt im Bereich von 30 - 60 mm, z.B. 35 mm.

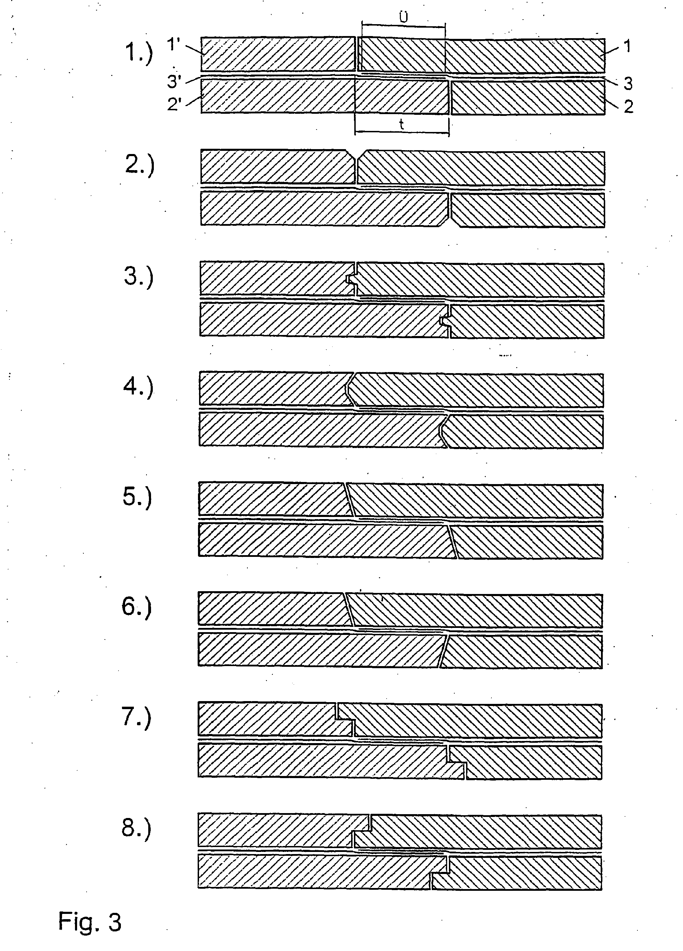

Die Kanten der Plattenelemente können in verschiedenen Formen ausgeführt werden. Dabei können alle Kanten in der gleichen oder in verschiedenen Ausführungen vorliegen. Die Wahl einer geeigneten Kantenform hängt u.a. von Plattenmaterial, Herstellung und Verwendung ab. Fig. 3 illustriert verschiedene Ausführungsformen wie gerade Kante (mit oder ohne Stufe (Nr 1, 7, 8); abgeschrägte Kante (Nr. 2, 4, 5, 6) oder Nut/Feder - Kante (Nr. 3). Die verschiedenen Kantenformen sind von der erfindungsgemässen Dämmplatte mit umfasst, bevorzugt sind Dämmplatten mit gerader Kante.

In einer besonders bevorzugten Ausführungsform betrifft die Erfindung eine mehrschichtige Dämmplatte bestehend aus zwei rechteckigen Plattenelementen (1), (2) und einer ganzflächig dazwischen liegenden rechteckigen Schutzschicht (3), dadurch gekennzeichnet, dass a)die Plattenelemente relativ zueinander versetzt befestigt sind, derart dass allseitig eine Stufe mit der Tiefe (t), (t') zwischen diesen Platten gebildet wird und b)die Schutzschicht die äussere Begrenzung (A), (A') bedeckt bzw. nahezu bedeckt.

In einem **zweiten Aspekt** betrifft die Erfindung ein Verfahren zur Herstellung einer Dämmplatte wie vorstehend beschrieben, dadurch gekennzeichnet, dass die Schutzschicht auf einem ersten Plattenelement positioniert und mit diesem verbunden wird und anschliessend ein zweites Plattenelement auf der anderen Seite der Schutzschicht positioniert und mit dieser verbunden wird.

In einer alternativen Ausführungsform betrifft die Erfindung ein Verfahren zur Herstellung einer Dämmplatte wie vorstehend beschrieben, dadurch gekennzeichnet, dass die beiden Plattenelemente und die Schutzschicht zunächst in der gewünschten Form positioniert werden (d.h so wie für die fertige Dämmplatte gewünscht), ggf. fixiert und anschliessend verbunden werden.

Die Verbindung von Plattenelementen und Schutzschicht kann, wie vorstehend beschrieben, mit allen gängigen Techniken des Formschlusses (z.B. mittels Clip, Klammer), Kraftschlusses (z.B. mittels Schrauben) oder Stoffschlusses (z.B. mittels Kleben oder Schweissen) erfolgen.

In einer bevorzugten Ausführungsform erfolgt die Verbindung der beiden Plattenelemente mit der Schutzschicht durch verkleben. Der Klebstoff muss dabei an die zu verbindenden Materialien angepasst werden; für die Verbindung von Holz oder Holzfasermaterialien und einer Schutzschicht aus Gewebematerial sind z.B. PVAc-Leim oder Silikate geeignet. Eine Verbindung durch Leimen hat den Vorteil, dass die Schutzschicht nicht beschädigt wird und ein einfacher Herstellungsprozess ermöglicht wird. Eine Verklebung kann vollflächig erfolgen oder nur in einzelnen Bereichen ("punktuell"). Bevorzugt ist eine punktuelle Verklebung, insbesondere derart, dass in der Überlappungszone kein Klebstoff aufgetragen wird.

In einer weiteren Ausführungsform erfolgt die Verbindung von Plattenelementen mit dazwischen liegender Schutzschicht - alternativ oder zusätzlich - mit mechanischen Verbindungselementen, wie Nägel, Schrauben. Clips.

Die so hergestellten Dämmplatten können direkt für den bestimmungsgemässen Gebrauch verwendet werden oder noch weiter verarbeitet werden. So können weitere Schichten auf die Plattenelemente aufgebracht werden oder zusätzliche Elemente befestigt werden, um spezifische Anforderungen zu genügen. Als Beispiel sei das Laminieren (z.B. mit einer witterungsbeständigen Schicht), das Lackieren (z.B. eines Farblackes) und das Anbringen von Montagelementen (z.B. für Befestigungszwecke) erwähnt.

In einem **dritten Aspekt** betrifft die Erfindung ein Verfahren zum Dämmen und Schützen von Gebäuden oder Gebäudeteilen, dadurch gekennzeichnet, dass mehrere Dämmplatten wie vorstehend beschrieben an Wänden und/oder Decken und/oder Böden der zu schützenden Gebäude oder Gebäudeteile bündig angebracht werden (,,verlegen der Dämmplatten"). Dieses Verfahren ist besonders vorteilhaft, da in einem einzigen Arbeitsgang ein Dämmen und Schützen von Gebäuden / Gebäudeteilen möglich ist. Durch die Struktur der Platten wird weiterhin sichergestellt, dass während des Verlegens keine Fehler auftreten, die Schutzschicht ganzflächig vorliegt und so ein vollständiger Schutz des Gebäudes / Gebäudeteils ermöglicht wird.

Um eine optimale Schutzwirkung zu erzielen, ist es notwendig, dass die Dämmplatten bündig angebracht werden: zwischen den einzelnen Dämmplatten soll kein Zwischenraum auftreten, die Schutzschicht muss auf der umlaufenden Stufen mit den Schutzschichten der angrenzenden Dämmplatten überlappen ("Überlappungszone"). Durch diesen angestrebten Verwendungszweck ergibt sich, dass für die Dämmplatten nur solche Geometrien geeignet sind, die eine bündige und flächige Verlegung erlauben, wie z.B. quadratisch, rechteckig oder sechseckig. Wegen Ihrer einfachen Herstellung und universellen Verwendung haben sich rechteckige Platten als vorteilhaft herausgestellt.

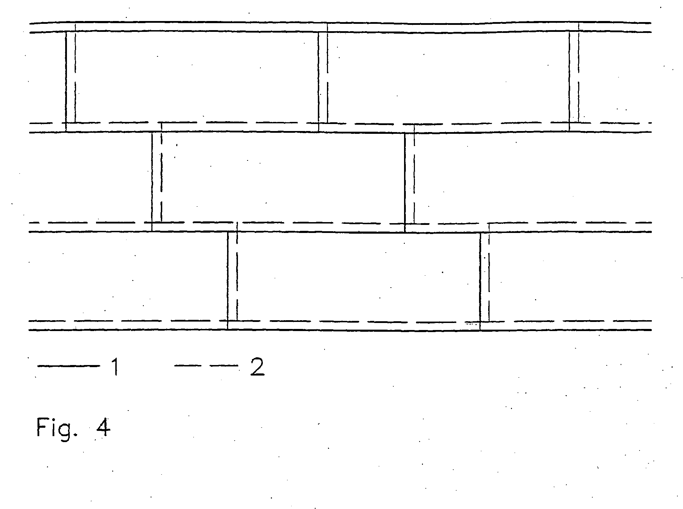

Werden rechteckige (oder quadratische) Dämmplatten verwendet, erfolgt die Verlegung bevorzugt derart, dass keine 4 Platten einen gemeinsamen Kreuzungspunkt aufweisen (Fig. 4).

Unter dem Begriff "Gebäude" werden alle Bauwerke zusammengefasst, die vor einer Einwirkung geschützt werden sollen; insbesondere Gebäude in denen sich Menschen aufhalten, wie Wohnhäuser, Bürogebäude, Montagehallen. Der Begriff Gebäudeteil bezieht sich entsprechend auf Dach, Wand, Boden, Raum und dergleichen. So kann es wünschenswert sein, lediglich einzelne Räume eines Gebäudes oder einzelne Teile eines Gebäudes mit den Dämmplatten wie hier beschrieben zu schützen.

Das Anbringen der Dämmplatten am Gebäude / Gebäudeteilen erfolgt auf an sich bekannte Art. Alle gängigen Verbindungstechniken des Formschlusses (z.B. mittels Clip, Klammer), Kraftschlusses (z.B. mittels Schrauben) oder Stoffschlusses (z.B. mittels Kleben oder Schweissen) sind geeignet, wobei die Art der Schutzschicht, der Plattenelemente und die Umwelteinflüsse berücksichtigt werden müssen. Im Falle einer elektrisch leitenden Schutzschicht ist es vorteilhaft der Korrosion, z.B. durch Wahl geeigneter Materialien zur Befestigung vorzubeugen.

Wie ausgeführt, bewirkt das Verlegen der erfindungsgemässen Dämmplatten wie hier beschrieben die Dämmung und den Schutz in einem einzigen Arbeitsgang. Dies ist zeit- und somit kosten-sparend. Des Weiteren bewirkt die Konstruktion der Dämmplatten eine besonders einfache und sichere Verlegung der Schutzschicht. Auch ist eine separate Befestigung der Schutzschicht nicht mehr notwendig.

In einem **vierten Aspekt** betrifft die Erfindung die Verwendung von Dämmplatten wie vorstehend beschrieben zur Dämmung und Schutz im Aussenbereich und Innenbereich von Gebäuden, insbesondere als Wand-Dämmplatte, Unterdachplatte, Trittschallplatte, Zwischenwand mit zusätzlicher Schutzwirkung.

Im Aussenbereich können die Dämmplatten wie hier beschrieben a) als Dach-Dämmplatte verwendet werden, wobei die Verlegung direkt auf den Sparren oder unter dem Unterdach möglich ist oder b) als Aussenwand-Dämmplatte verwendet werden, wobei die Verlegung unter Putz (bei Kompaktbauweise)- z.B. auch als Putzträgerplatte - oder bei hinterlüfteten Fassaden möglich ist.

Im Innenbereich können die Dämmplatten wie hier beschrieben a) als Dach-Dämmplatte verwendet werden, wobei die Verlegung unter den Sparren möglich ist oder b) als Dämmplatte für Decken, Innenwände, Trennwände oder c) als Dämm- oder Trittschallplatten im Bodenbereich.

Insbesondere betrifft die vorliegende Erfindung auch die Verwendung in einem dieser Bereiche zum Schutz vor elektromagnetischer oder elektrischer Strahlung.

Die beigefügten Figuren sollen die Erfindung weiter verdeutlichen, ohne sie zu limitieren. Die angegebenen Bezugszeichen haben dabei folgende Bedeutung:
(1) oberes Plattenelement
(2) unteres Plattenelement
(3) Schutzschicht
(4) und (4') Stufe
(A) und (A') äussere Begrenzung der Dämmplatte
(ü) Überlappungszone
(t) und (t') Tiefe der Stufe

Fig. 1 zeigt eine erfindungsgemässe Dämmplatte in der Aufsicht. Gezeigt ist die äussere Begrenzung der Dämmplatte (A, A'), die durch Verschieben der Plattenelemente um den Betrag (t) in x-Richtung und den Betrag (t') in y-Richtung entsteht. Ebenfalls gezeigt ist die Überlappungszone (ü), in dem die Schutzschicht (3) mit einer weiteren Schutzschicht (3) einer benachbarten Dämmplatte überlappt. Sofern die Schutzschicht (3) mit der äusseren Begrenzung abschliesst, sind Überlappungstiefe und Stufentiefe identisch. Es ist darauf zu achten, dass eine ausreichend grosse Überlappungszone entsteht. Bedeckt die Schutzschicht weniger als die halbe Stufentiefe, ist keine Überlappung mehr möglich.
Fig. 2 zeigt zwei bündig miteinander verlegte Dämmplatten in der Seitenansicht mit gerader Schnittkante
Fig. 3 zeigt Detailansichten von bündig miteinander verlegten Dämmplatten in der Seitenansicht, wobei verschiedene mögliche Kantenprofile dargestellt werden Fig. 4 zeigt ein Muster für die Verlegung der erfindungsgemässen Dämmplatten. Bei der gezeigten Art der Verlegung weisen lediglich 3 Platten einen gemeinsamen Kreuzungspunkt auf. An den Kreuzungspunkten liegt die Schutzschicht 3-lagig übereinander vor.

Das nachfolgende **Beispiel** soll die Erfindung weiter verdeutlichen, ohne sie zu limitieren:

### Beispiel 1:

Dämmplatte: 4 Dämmplatten wurden hergestellt aus jeweils zwei Holzfaserweichplatten (Fa. Pavatex, Dicke 17.5 mm, Länge 2500, Breite 770)und einer mittig liegenden Schutzschicht aus Cuprotect Spezial (feinmaschiges Reinkupfergewebe, E-CU58; Länge 2550, Breite 820). Die Holzfaserweichplatten wurden umlaufend um 50 mm versetzt positioniert, die Schutzschicht flächig und mittig dazwischen positioniert und mit PVAc-Leim verklebt. Die eingeklebte Schutzschicht hat die Grösse der Aussenmasse (A, A') des Sandwichelements.

Prüfwand: 4 Platten wurden zu einer Prüfwand zusammengesetzt und mit Kunststoffdübeln an einer Wand befestigt, wobei diese Dübel beide Platten und die Schutzschicht durchdringen. Die Nahtverbindungen zwischen den Dämmplatten wurden durch übereinander legen ohne verkleben erstellt.

Prüfverfahren: Nachstehende Tabelle gibt die einzelnen Parameter der Messung wieder.
- Messmethode:: MIIL-STD 188-125-2:11999-03-03
- Frequenzbereich:: 100 kHz - 30 Mhz (H-Feld)
20 MHz - 3 GHz (E-Feld)
- Polarisation:: horizontal und vertikal
- Schrittweite:: 1 % log
- Geometrien:: Abstand Sende- Empfangsantenne 250 cm Abstand Sendeantenne - Prüfmuster 150 cm - Dicke Prüfmuster Höhe Antennen 150 cm
- Berechnung der Dämpfung:: Attenuation (dB) = Pegel bis Referenzmessung - Pegel bei Messung des Prüfmusters
- Dynamikbereich:: 85 dB

Ergebnisse: Im gesamten Frequenzbereich wurde für das H-Feld (horizontal und vertikal) eine Attenuation von über 50 dB; für das E-Feld (horizontal und vertikal) eine Attenuation von über 40 dB bestimmt. Dieses Ergebnis zeigt eindrücklich, dass die einzelnen Dämmplatten sowie deren Verlegetechnik hervorragend geeignet sind, elektrische, magnetische und elektromagnetische Felder abzuschirmen.

## Patentansprüche

1. Mehrschichtige Dämmplatte bestehend aus zwei Plattenelementen und mindestens einer ganzflächig dazwischen liegenden Schutzschicht, **dadurch gekennzeichnet, dass**
a.die Plattenelemente relativ zueinander versetzt befestigt sind, derart dass allseitig eine Stufe zwischen diesen Plattenelementen gebildet wird ;
b.die Schutzschicht mehr als die Hälfte der gebildeten Stufe bedeckt und bevorzugt im Wesentlichen nicht über die äussere Begrenzung der Dämmplatte hinausreicht;
c. die Schutzschicht aus einer elektrisch leitenden Folie und/oder einem elektrisch leitenden Gewebe oder Gelege besteht und
d.die Plattenelemente aus einem Kunststoffmaterial und/oder Holzfasermaterial und/oder Holz bestehen.

2. Dämmplatte gemäss Anspruch 1, **dadurch gekennzeichnet, dass** die zwei Plattenelemente identische Dimensionen aufweisen.

3. Dämmplatte gemäss einem der vorangehenden Ansprüche, **dadurch gekennzeichnet, dass** die Plattenelemente eine Sandwichstruktur aufweisen; insbesondere Plattenelemente aus Holzfaserplatten unterschiedlicher Dichte oder beschichtete / lackierte Kunststoffplatten.

4. Dämmplatte gemäss einem der vorangehenden Ansprüche, **dadurch gekennzeichnet, dass** die Schutzschicht aus einem Kupferdrahtgewebe mit einer Maschenweite von < 5 mm besteht.

5. Dämmplatte gemäss einem der vorangehenden Ansprüche, **dadurch gekennzeichnet, dass** die Plattenelemente Holzweichfaserplatten sind.

6. Dämmplatte gemäss einem der vorangehenden Ansprüche, **dadurch gekennzeichnet, dass** die Stufe, welche durch die Plattenelemente gebildet wird, eine Tiefe von 10 - 100 mm aufweist.

7. Dämmplatte gemäss einem der vorangehenden Ansprüche, **dadurch gekennzeichnet, dass** die Kanten der Plattenelemente als Stufenfalz mit gerader Kante oder als Stufenfalz mit abgeschrägter Kante oder als Nut/Feder - Kante ausgebildet sind.

8. Verfahren zur Herstellung einer Dämmplatte gemäss einem der vorangehenden Ansprüche, **dadurch gekennzeichnet, dass** die Schutzschicht auf einem ersten Plattenelement positioniert und mit diesem verbunden wird und anschliessend ein zweites Plattenelement auf der anderen Seite der Schutzschicht positioniert und mit dieser verbunden wird.

9. Verfahren zum Dämmen und Schützen von Gebäuden oder Gebäudeteilen, **dadurch gekennzeichnet, dass** mehrere Dämmplatten gemäss einem der Ansprüche 1 bis 8 bündig an den Wänden und/oder Decken und/oder Böden der zu schützenden Gebäude oder Gebäudeteilen angebracht werden, bevorzugt derart, dass keine 4 Platten einen gemeinsamen Kreuzungspunkt aufweisen.

10. Verwendung von Dämmplatten gemäss einem der Ansprüche 1 bis 7 als Wand-Dämmplatte, Unterdachplatte, Trittschallplatte, Zwischenwand oder als Dämm- oder Trittschallplatte im Bodenbereich.

## Claims

1. Multilayer insulating panel consisting of two panel elements and at least a protective layer arranged on the entire surface in between, **characterized in that**
a) the panel elements are attached shifted relatively to each other, in such a way that on all sides a step between these panels is formed;
b) the protective layer covers more than half of the formed step and does preferably not reach out beyond the outer boundary of the insulating panel;
c) the protective layer consists of an electroconductive foil and/or of an electroconductive tissue or fabric and
d) the panel elements consist of a plastic material and/or a wood fibre material and/or wood.

2. Insulating panel according to claim 1, **characterized in that** the two panel elements have identical dimensions.

3. Insulating panel according to one of the preceding claims, **characterized in that** the panel elements have a sandwich structure; particularly panel elements of wood fibre panels of different density or coated/painted plastic panels.

4. Insulating panel according to one of the preceding claims, **characterized in that** the protective layer is made of a copper wire tissue with a mesh width of < 5 mm.

5. Insulating panel according to one of the preceding claims, **characterized in that** the panel elements are wood soft fibre plates.

6. Insulating panel according to one of the preceding claims, **characterized in that** the step, which is formed by the panel elements, has a depth of 10 - 100 mm.

7. Insulating panel according to one of the preceding claims, **characterized in that** the edges of the panel elements are formed as stepped profiles with even edge or as stepped profiles with bevelled edges or as groove/spring edge.

8. Method for manufacturing an insulating panel according to one of the preceding claims, **characterized in that** the protective layer is positioned on a first panel element and attached to it and subsequently a second panel element is positioned on the other side of the protective layer and attached to it.

9. Method for insulating and protecting buildings or building parts, **characterized in that** a plurality of insulating panels according to one of the claims 1 to 8 are flushly attached to the walls and/or ceilings and/or floors of the building or building part to be protected, preferably in such a way that no 4 panels have a common intersection point.

10. Use of insulating panels according to one of the claims 1 to 7 as wall insulating panel, underroof panel, tread sound panel, dividing wall or as insulating- or tread sound panel in the floor area.

## Revendications

1. Plaque isolante multicouche constituée de deux éléments de plaque et d'au moins une couche de protection intercalaire qui en couvre toute la surface, **caractérisée en ce que**
a. les éléments de plaque sont fixés en décalage mutuel de manière à former sur tous leurs côtés un gradin entre ces éléments de plaque,
b. la couche de protection couvre plus de la moitié du gradin ainsi formé et ne déborde de préférence essentiellement pas au-delà de la limite extérieure de la plaque isolante,
c. la couche de protection est constituée d'une feuille électriquement isolante et/ou d'un tissu ou d'une couche électriquement isolants et
d. les éléments de plaque sont constitués d'un matériau à base de matière synthétique, d'un matériau à base de fibres de bois et/ou de bois.

2. Plaque isolante selon la revendication 1, **caractérisée en ce que** les deux éléments de plaque ont les mêmes dimensions.

3. Plaque isolante selon l'une des revendications précédentes, **caractérisée en ce que** les éléments de plaque présentent une structure en sandwich et sont en particulier des éléments de plaque constitués de plaques en fibres de bois d'épaisseurs différentes et/ou de plaques en matière synthétique revêtues ou peintes.

4. Plaque isolante selon l'une des revendications précédentes, **caractérisée en ce que** la couche de protection est constituée d'un tissu en fibres de cuivre d'une maille < 5 mm.

5. Plaque isolante selon l'une des revendications précédentes, **caractérisée en ce que** les éléments de plaque sont des plaques en fibres déformables de bois.

6. Plaque isolante selon l'une des revendications précédentes, **caractérisée en ce que** le gradin formé par les éléments de plaque présente une épaisseur de 10 à 100 mm.

7. Plaque isolante selon l'une des revendications précédentes, **caractérisée en ce que** les chants des éléments de plaque sont configurés sous la forme de mortaises en gradin à chant rectiligne ou de mortaises en gradin à chant oblique ou comme chant à rainure et languette.

8. Procédé de fabrication d'une plaque isolante selon l'une des revendications précédentes, **caractérisé en ce que** la couche de protection est placée sur un premier élément de plaque et est reliée à ce dernier et **en ce qu'**un deuxième élément de plaque est ensuite placé sur l'autre côté de la couche de protection et relié à cette dernière.

9. Procédé d'isolation et de protection de bâtiments ou de parties de bâtiments, **caractérisé en ce que** plusieurs plaques isolantes selon l'une des revendications 1 à 8 sont posées chant contre chant sur les parois, les plafonds et/ou les planchers du bâtiment ou de parties de bâtiments à protéger, de préférence de telle sorte que quatre plaques ne forment pas un point de croisement commun.

10. Utilisation de plaques isolantes selon l'une des revendications 1 à 7 comme plaques isolantes de parois, plaques isolantes de sous-toitures, plaques isolant du bruit de marche, cloison intermédiaire ou comme plaques isolantes ou d'isolation contre le bruit de marche sur les planchers.
